Europäisches Patentamt

European Patent Office

Office européen des brevets

(11) Publication number: 0 480 197 A1

# EUROPEAN PATENT APPLICATION

(21) Application number: 91115533.1

(22) Date of filing: 13.09.91

(51) Int. Cl.⁵: H01L 21/56, H01L 23/433

(30) Priority: 09.10.90 IT 2168190

(43) Date of publication of application:
15.04.92 Bulletin 92/16

(84) Designated Contracting States:
DE FR GB SE

(71) Applicant: SGS-THOMSON
MICROELECTRONICS s.r.l.
Via C. Olivetti, 2
I-20041 Agrate Brianza Milano(IT)

(72) Inventor: Marchisi, Guiseppe
Via A. Pecorini, 8
I-20138 MILANO(IT)
Inventor: Lamourelle, François
2, Rue Servan
F-3800 GRENOBLE(FR)

(74) Representative: Perani, Aurelio et al
c/o JACOBACCI-CASETTA & PERANI Via
Visconti di Modrone 7
I-20122 Milano(IT)

(54) A method for manufacturing plastics IC packages incorporating a heat sink.

(57) In a method for manufacturing plastics packages for integrated circuits (2) incorporating a heat sink (8), the heat sink (8) is positioned on a mold (10) bottom (13) against which it is held pneumatically in fluid-tight relationship.

FIG.2

This invention relates to a method for manufacturing plastics IC packages incorporating a heat sink, being of the type wherein the heat sink is placed on the bottom of a mold.

It is known that in the specific technical field of this invention, many plastics packages incorporate a metal body adapted to promote dissipation of heat generated by the operation of an integrated circuit enclosed therein.

Such are for instance, the packages for most power integrated circuits.

A number of different methods of making these packages have been proposed in the prior art, of which methods the most widely used one comprises the following steps:

A very thin metal foil is provided, as by blanking, with a rest central portion from which a plurality of flat conductors extends.

The central portion accommodates a semiconductor integrated circuit, with its substrate directly contacting said portion.

Selected areas of the integrated circuit are connected electrically to said conductors.

A metal body acting as a heat sink is soldered to the central portion of the foil, on the side thereof opposite to the IC.

Lastly, the completed foil with the IC and the heat sink is incorporated into a resin body formed, for example, by injecting a thermosetting plastic material, such as an epoxy resin, into a suitable mold.

To prevent the thin conductors of the foil from touching one another during the injection step, it matters that the resin be highly flowable.

However, this has the disadvantage that plastics flash often appears on the heat sink from imperfect mating of the heat sink with the mold.

Known are methods directed to improve the adhesion of the heat sink to the mold, such as by pushing on the foil to force the heat sink against the mold. Such a method cannot be applied, however, to integrated circuits of comparatively large size and associated with unusually thin foils.

Flash is customarily removed by subjecting the package to an additional process step of abrasive machining of the exposed surface of the heat sink.

It may be appreciated that this reflects adversely on production costs and times, adding to the cost of the end product.

The underlying technical problem of this invention is to provide a method which can yield packages virtually free of plastics flash on the exposed surface of the heat sink.

The idea on which this invention is based is to hold the heat sink against the mold pneumatically.

Based upon this idea, the technical problem is solved by a method as indicated above which is characterized in that said heat sink is held close against the mold bottom in fluid-tight relationship therewith pneumatically.

The features and advantages of a method according to the invention will become apparent from the following detailed description of an embodiment thereof, given by way of example and not of limitation with reference to the accompanying drawing.

In the drawing:

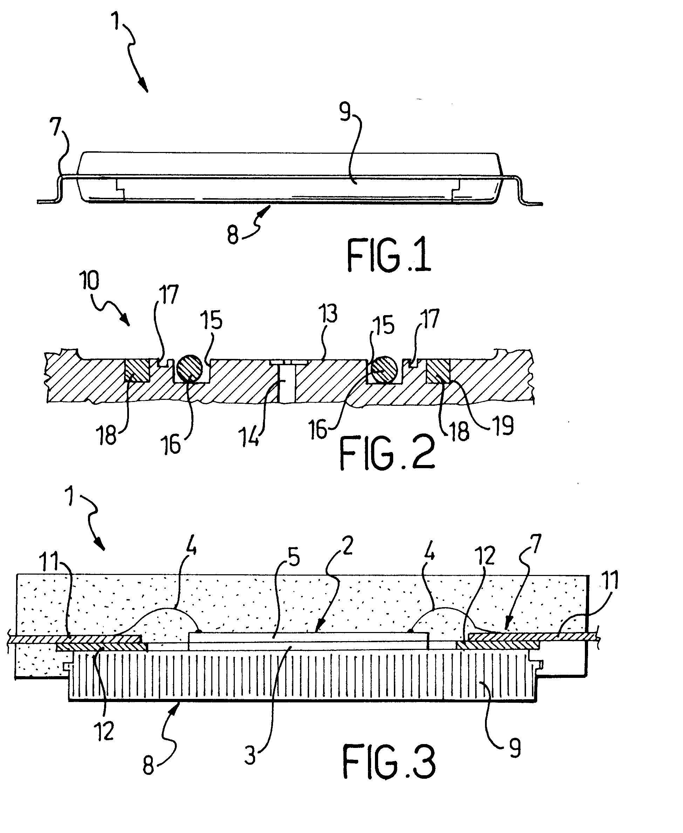

Figure 1 is a side view showing schematically a plastics package as formed with the method of this invention;

Figure 2 is a cross-sectional view showing to an enlarged scale a portion of a mold for forming plastics packages as in Figure 1; and

Figure 3 is an enlarged scale view showing in vertical section the plastics package of Figure 1.

With reference to the drawing views, generally shown at 1 is a package made of a plastics material and intended for containing and protecting a semiconductor integrated circuit 2 therein.

The package 1 is formed by first defining a rest central portion 3 on a very thin metal foil 7 wherein plural flat thin conductors are also defined, as by blanking or etching, which branch off the central portion 3.

Such conductors extend near-radially around the central portion 3 on which a semiconductor silicon chip 5 rests which carries the integrated circuit 2.

The substrate of the chip 5 is bonded to the central portion 3, and selected areas of the integrated circuit 2 are connected electrically to the conductors by wires 4.

The above process steps form part of a conventional manufacturing method wherein the foil 7 is also provided with a so-called heat sink 8.

This heat sink 8 is basically a metal body soldered to the central portion 3 of foil 7, on the side thereof opposite to the chip 5. Specifically, the heat sink 8 is a metal disk 9 on which the central portion 3 is secured, while peripheral portions 11 of the foil 7 are arranged to rest on the disk 9 through an intervening layer 12 of an insulating material.

Advantageously, the completed foil 7 with the chip 5 and the metal disk 9 is introduced into a mold 10 whereinto a resin, such as a thermosetting polymer, is injected while in a liquid state.

The foil 7 is fitted into the mold with the metal disk 9 directly contacting the bottom 13 of the mold.

In the method of this invention, the metal disk 9 is held close against the bottom 13 of the mold 10 pneumatically.

To this aim, the bottom 13 is passed through by a hole 14 to permit of the creation of a vacuum as by suction underneath the disk 9, thereby developing a pneumatic attraction force between the disk and the bottom 13.

Advantageously, the disk 9 is held in fluid-tight contact with the bottom 13. To this aim, the mold 10 is formed with an annular seat 15 for a sealing ring 16 having a slightly larger thickness than the depth of the seat 15. Consequently, the ring 16 will protrude somewhat above the seat 15 and become compressed by the pneumatic attraction force acting between the disk 9 and the bottom 13 of the mold 10, thereby a fluid-tight seal can be provided.

The structure of the mold 10 further includes provisions to ensure that in all cases at least a selected area of the exposed surface of the heat sink 8 will be entirely free of any plastics material flash.

As an example, the seat 15 is encircled on the bottom 13 by an annular channel 17 adapted to form a barrier to the overflow of resin in the liquid state.

In addition, a seal 18 of square cross-sectional shape is received in a further annular seat 19 encircling the channel 17 and having substantially the same O.D. as the disk-shaped heat sink 9.

Accordingly, this seal 18 will be also compressed by the peripheral edge of the disk 9 under the pneumatic attraction force which holds the disk against the bottom 13.

From a working standpoint, the steps of the method according to the invention are carried out chronologically in the following sequential order:

After the foil 7 is introduced into the mold 10, the means is operated for creating a vacuum beneath the heat sink 8. On achieving a truly tight fit of the metal disk 9 on the seals 16 and 18 at the bottom 13 of the mold 10, the injection of resin in a liquid state is started.

On the resin setting, the vacuum forming means is de-activated and the metal disk 9 will separate automatically from the mold 10 bottom, making for easier removal of the package 1 through conventional shake-out means.

At this stage, the package 1 can be fitted to any printed circuit.

It may be appreciated from the foregoing description that a major advantage of the inventive method is that it enables plastics packages to be formed with no flash on the exposed surface of the heat sink incorporated thereto.

Understandably, this results in lower production costs and overall cost of the end product.

This method can be applied to the manufacture of any plastics packages incorporating a heat sink, but is specially useful where the integrated circuit, or the foil carrier, is to undergo no excessive mechanical stresses.

## Claims

1. A method for manufacturing plastics IC (2) packages incorporating a heat sink (8), being of the type wherein the heat sink (8) is placed on the bottom (13) of a mold (10), characterized in that said heat sink (8) is held close against the mold (10) bottom (13) in fluid-tight relationship therewith pneumatically.

2. A method according to Claim 1, characterized in that the pneumatic action holding said heat sink (8) close against the mold (10) bottom (13) is brought about by application of a suction at a central hole (14) formed through said bottom (13).

3. A method according to Claim 1, characterized in that the fluid-tight relationship is established by holding the heat sink (8) against at least one ring seal (16,18) placed in a corresponding seat (15,19) provided in said mold (10).

EP 0 480 197 A1

FIG.1

FIG.2

FIG.3

4

European
Patent Office

EUROPEAN SEARCH
REPORT

Application Number

EP 91 11 5533

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 014, no. 225 (E-092)14 May 1990 & JP-A-02 058 243 ( CITIZEN WATCH CO LTD. ) 27 February 1990 * abstract * * | 1,2 | H 01 L 21/56 H 01 L 23/433 |
| | – – – | | |
| X | EP-A-0 277 854   (SCHLUMBERGER INDUSTRIES) * page 3, column 4, line 14 - line 58 * * | 1,2 | |
| A | | 3 | |
| | – – – | | |
| X | EP-A-0 128 822   (FLONIC SA.) * the whole document * * | 1,2 | |
| | – – – | | |
| X | GB-A-2 164 794   (OY LOHJA AB) * page 1, line 36 - line 49 * * page 2, line 90 - line 95; figures 7,10 * * | 1,2 | |
| | – – – | | |
| X | PATENT ABSTRACTS OF JAPAN vol. 013, no. 062 (E-715)13 February 1989 & JP-A-63 250 846 ( HITACHI LTD. ) 18 October 1988 * abstract * * | 1,2 | |
| | – – – | | TECHNICAL FIELDS SEARCHED (Int. Cl.5) |
| A | PATENT ABSTRACTS OF JAPAN vol. 014, no. 036 (E-877)23 January 1990 & JP-A-01 270 335 ( HITACHI LTD. ) 27 October 1989 * abstract * * | 1,2 | H 01 L |
| | – – – | | |
| A | PATENT ABSTRACTS OF JAPAN vol. 005, no. 003 (E-040)10 January 1981 & JP-A-55 134 940 ( CITIZEN WATCH CO LTD. ) 21 October 1980 * abstract * * | 1,2 | |
| | – – – | | |
| | –/– | | |

The present search report has been drawn up for all claims

| Place of search | Date of completion of search | Examiner |
|---|---|---|
| The Hague | 28 January 92 | ZEISLER P.W. |

**European Patent Office**

# EUROPEAN SEARCH REPORT

**EP 91 11 5533**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN vol. 011, no. 329 (E-552)27 October 1987 & JP-A-62 115 834 ( MATSUSHITA ELECTRONICS CORP. ) 27 May 1987 * abstract * * | 1,2 | |
| A | EP-A-0 338 199   (INTERNATIONAL BUSINESS MACHINES CORP.) * the whole document * * | 1,2 | |

TECHNICAL FIELDS SEARCHED (Int. Cl.5)

The present search report has been drawn up for all claims

| Place of search | Date of completion of search | Examiner |
|---|---|---|
| The Hague | 28 January 92 | ZEISLER P.W. |